# EUROPÄISCHE PATENTANMELDUNG

(11) **EP 1 265 473 A2**
(43) Veröffentlichungstag der Anmeldung: **11.12.2002**
(21) Anmeldenummer: 02012272.7
(22) Anmeldetag: 05.06.2002
(51) Int. Cl.: H05K 13/00

(54) **Anordnung zur Lagerung von Transportwalzen**

(30) Priorität: 06.06.2001 DE 10128386
(71) Anmelder: Gebr. Schmid GmbH & Co., D-72250 Freudenstadt (DE)
(72) Erfinder: Kappler, Heinz, 72280 Dornstetten-Aach (DE)
(74) Vertreter: Patentanwälte Ruff, Wilhelm, Beier, Dauster & Partner

(57) **Zusammenfassung**

Eine Anordnung zur Lagerung von Transportwalzen in einer Anlage zur Behandlung von Leiterplatten enthält Träger mit Einsätzen für die Enden der Walzen. Die Einsätze sind so ausgebildet, dass ihre parallelen die Lagerung bildenden einander zugewandten Innenwände derart auf Abstand gehalten werden, dass sie ihre Parallelität beibehalten.

## Beschreibung

Die Erfindung geht aus von einer Anlage zur Herstellung von Leiterplatten. Leiterplatten werden in solchen Anlagen mit Hilfe von Transportwalzen transportiert. Sie werden dabei während bestimmter Arbeitsschritte in chemischen Bädern angeordnet.

Für das Transportsystem verwendet man ein Trägersystem, das in den meisten Fällen aus Kunststoff hergestellt ist, zum Beispiel PE, PP, PVC oder PVDF. Dazu werden Träger verwendet, die Aufnahmen für die Enden der Transportwalzen aufweisen. Die Enden stehen dabei über die Träger auch etwas auf die gegenüberliegende Seite vor, wo sie häufig mit Antriebszahnrädern versehen sind. Die Transportachsen sind aus Titan, Edelstahl oder PTFE hergestellt. Durch die rotierenden Transportwalzen nutzen sich die Träger, in Abhängigkeit von den auf sie einwirkenden chemischen Stoffen, mehr oder weniger stark ab. Sie müssen daher nach einer bestimmten Zeit erneuert werden. Die Abnutzung der Vorschubträger kann auch von der Position innerhalb des Moduls und von der Wellenbestückung abhängig sein. Die Abnutzung kann innerhalb eines Moduls daher unterschiedlich sein.

Damit nicht der komplette Träger ausgetauscht werden muss, werden die Vorschubträger mit auswechselbaren Lagereinsätzen ausgerüstet. Die Austauschbarkeit von Lagereinsätzen ist bekannt.

Der Erfindung liegt die Aufgabe zu Grunde, Anlagen zur Bearbeitung von Leiterplatten im Hinblick auf eine größere Einsatzfähigkeit zu verbessern.

Zur Lösung dieser Aufgabe schlägt die Erfindung einer Anordnung mit den im Anspruch 1 genannten Merkmalen vor. Weiterbildungen der Erfindung sind Gegenstand von Unteransprüchen.

Bei den bisher bekannten Einsätzen bestand die Gefahr, dass sich ihre Innenwände, die an sich parallel sein sollen, im Betrieb einander annähern, so dass sie die in ihnen gelagerten Wellen der Transportwalzen an der Drehung hindern. Durch die Maßnahmen der Erfindung wird diese Annäherung dadurch verhindert, dass die Wände in ihrer parallelen ursprünglichen Ausrichtung festgehalten werden.

Erfindungsgemäß können die Aufnahmen der Träger als oben offene Schlitze ausgebildet sein. Die Lagereinsätze können dann von oben her in die Aufnahmen eingeschoben werden.

Erfindungsgemäß kann vorgesehen sein, dass die Einsätze für die Lagerungen der Wellen einen seine Innenwände verbindenden kreiszylindrischen Endabschnitt aufweisen. Die Wellen werden also über die Hälfte ihres Umfangs gelagert.

Zum Einschieben der Einsätze in die Träger bzw. deren Aufnahmen kann erfindungsgemäß vorgesehen sein, dass die Träger mit den Einsätzen zusammenwirkende Führungen aufweisen.

Eine Möglichkeit, wie die Beibehaltung der Parallelität der Innenwände der Einsätze gewährleistet werden kann, besteht darin, dass die Führungen einen Hinterschnitt bilden bzw. aufweisen. Damit wird dann verhindert, dass die Einsätze sich so verformen, dass ihre Innenwände sich einander annähern.

Der Hinterschnitt kann beispielsweise durch Nuten und/oder Rippen in den senkrecht zur Drehachse der Transportwalzen verlaufenden Seitenwänden der Träger gebildet werden.

Eine weitere Möglichkeit zur Bildung des Hinterschnitts kann darin bestehen, dass dieser durch hinterschnittene Nuten und/oder Rippen in den einander zugewandten Seitenwänden der Träger und entsprechend komplementäre Ausbildungen der Einsätze gebildet wird.

In nochmaliger Weiterbildung der Erfindung kann vorgesehen sein, dass in den Einsatz zur Lagerung der Wellen ein Distanzeinsatz eingebracht werden kann, der den Abstand zwischen den einander zugewandten Innenwänden des Einsatzes ausfüllt. Dieser Distanzeinsatz kann dazu dienen, einen Flüssigkeitsaustritt aus dem Bad, in dem die Leiterplatten untergebracht sind, nach außen zu verhindern. Gleichzeitig lässt er aber die Möglichkeit bestehen, durch Entfernen des Einsatzes die Transportwelle nach oben herauszunehmen. Es ist daher zum Austausch der Einsätze nicht erforderlich, ein an der Außenseite des Trägers an der Welle befestigtes Zahnrad zu entfernen.

Der Distanzschieber kann beispielsweise von der offenen Oberseite her in den Einsatz einschiebbar sein. Hierzu kann eine Führung vorgesehen sein, die derart ausgebildet sein kann, dass sie den Distanzeinsatz gegen ein Herausschieben in Richtung der Transportwalzen sichert.

Der Distanzschieber kann an seiner der Welle zugeordneten Unterseite und/oder seiner Oberseite eine konkave Krümmung aufweisen, die dem Durchmesser des zu lagernden Teils der Walze entspricht. Der Distanzeinsatz dient auch dazu, eine obere Walze zu lagern und in ihrer Position festzulegen.

Weitere Merkmale, Einzelheiten und Vorzüge der Erfindung ergeben sich aus der folgenden Beschreibung bevorzugter Ausführungsformen der Erfindung, den Patentansprüchen und der Zusammenfassung, deren Wortlaut durch Bezugnahme zum Inhalt der Beschreibung gemacht wird, sowie an Hand der Zeichnung. Hierbei zeigen:
- Figur 1: eine Seitenansicht eines Trägers für Transportwalzen;
- Figur 2: eine Aufsicht auf einen Träger der Figur 1;
- Figur 3: einen Querschnitt durch den Träger der Figur 1 längs Linie III-III in Figur 1;
- Figur 4: einen Querschnitt durch den Träger längs Linie IV-IV in Figur 1;
- Figur 5: in vergrößertem Maßstab einen Längsschnitt durch einen Einsatz für eine Aufnahme des Trägers der Figur 1;
- Figur 6: eine Aufsicht auf einen Einsatz von oben in Figur 5;
- Figur 7: eine der Figur 6 entsprechende Aufsicht auf einen Einsatz bei einer zweiten Ausführungsform;
- Figur 8: schematisch das Zusammenwirken eines Einsatzes der Figur 6 mit einem Träger;
- Figur 9: auseinandergezogen die gegenseitige Zuordnung von Träger, Einsatz und Distanzeinsatz;
- Figur 10: eine der Figur 6 entsprechende Aufsicht auf einen Einsatz bei einer anderen Ausführungsform.

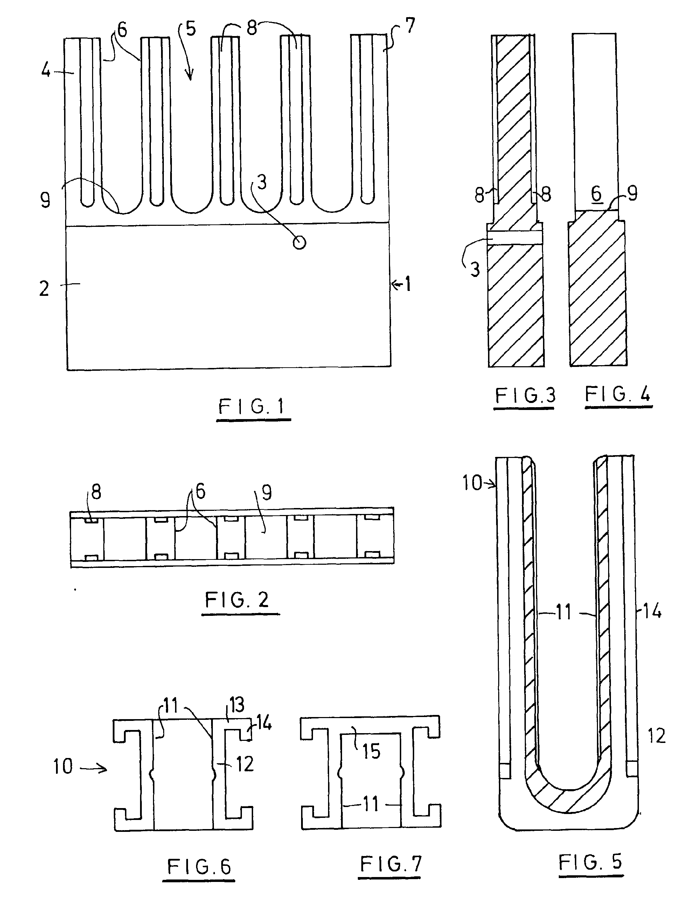

Figur 1 zeigt in einer Seitenansicht einen Träger 1, der zur Lagerung mehrerer Transportwalzen in einer Vorrichtung zur Bearbeitung von Leiterplatten gedacht ist. Der Träger enthält einen Sockelteil 2 mit mehreren Bohrungen 3 sowie einen sich daran anschließenden Abschnitt 4 mit mehreren Aufnahmen 5 für die Enden der Transportwalzen. Die Aufnahmen 5 sind als Schlitze ausgebildet, die an ihrer Oberseite offen sind. Sie enthalten zwei parallele Seitenwände 6, die damit die Aufnahme begrenzen. Sichtbar ist in Figur 1 eine Seitenwand 7, die senkrecht zu der Drehachse der Transportwalzen verläuft. Die Drehachse der Transportwalzen verläuft senkrecht zur Zeichnungsebene. Neben den Aufnahmen 5 für die Enden der Transportwalzen enthält die Seitenwand 7 parallel zu den Seitenwänden 6 der Aufnahmen 5 verlaufende Nuten 8, die etwa die gleiche Länge wie die die Aufnahmen 5 bildenden Schlitze aufweisen. Mit Ausnahme der ersten und letzten Aufnahme 5 ist jede Nut 8 für zwei benachbarte Aufnahmen 5 zuständig.

Der Schnitt der Figur 3 ist so gelegt, dass er durch die Nuten 8 auf der Vorderseite und Rückseite des Trägers hindurch gelegt ist.

Figur 2 zeigt in einer Aufsicht, dass die Nuten 8 von der Oberseite her ausgehen. Die Aufnahmen 5 für die Enden der Transportwalzen enden in einem Bogen 9.

Der Bogen 9 ist auch in dem Schnitt der Figur 4 zu sehen, der so gelegt ist, dass er mittig zwischen zwei einander zugewandten Seitenwänden 6 einer Aufnahme 5 verläuft.

Figur 5 zeigt in vergrößertem Maßstab einen Lagereinsatz 10, der als U-förmiges Einsatzteil ausgebildet ist und in die Aufnahmen 5 von oben her einschiebbar ist. Auch der Lagereinsatz 10 weist zwei parallel zueinander verlaufende Innenwände 11 auf, deren Abstand etwa dem Durchmesser des zu lagernden Endes einer Transportwalze entspricht. Im unteren Bereich sind die beiden parallelen Innenwände 11 durch einen Bogen 12 miteinander verbunden. Der Bogen 12 verläuft längs eines Kreiszylinders.

Die Querschnittsform des Lagereinsatzes 10 geht aus Figur 6 hervor, die eine Aufsicht auf den Lagereinsatz 10 von oben her darstellt. Der Querschnitt beider Schenkel des Lagereinsatzes 10 ist etwa C-förmig ausgebildet. Senkrecht zu den die Innenwände 11 bildenden Stegen 12 verlaufen nach außen gerichtete Stege 13, die in ihren Endbereichen wieder um 90° nach innen gebogen sind und dort Rippen 14 bilden. Die Rippen 14 sind so dimensioniert, dass sie in die Nuten 8 der Seitenwände 7 der Träger 1 eingreifen können. Der Innenabstand zwischen den einander zugewandten Seiten der Stege 13 entspricht der Breite des Trägers 1 zwischen den Nutgründen gemessen.

Figur 7 zeigt eine geänderte Ausführungsform, bei der der Innenraum zwischen den beiden Innenwänden 11 auf der einen Seite durch einen durchgehenden Steg 15 geschlossen ist. Der Lagereinsatz der Figur 7 ist für solche Wellen bestimmt, die stumpf enden, also nicht durch die Träger 1 hindurch gehen. Der Lagereinsatz der Figur 6 ist für solche Wellen gedacht, bei denen die zu lagernden Wellen durch den Träger 1 hindurch gehen, so dass sie auf der gegenüberliegenden Seite mit einer Verzahnung, einem Zahnrad oder einer sonstigen Einrichtung versehen sein können.

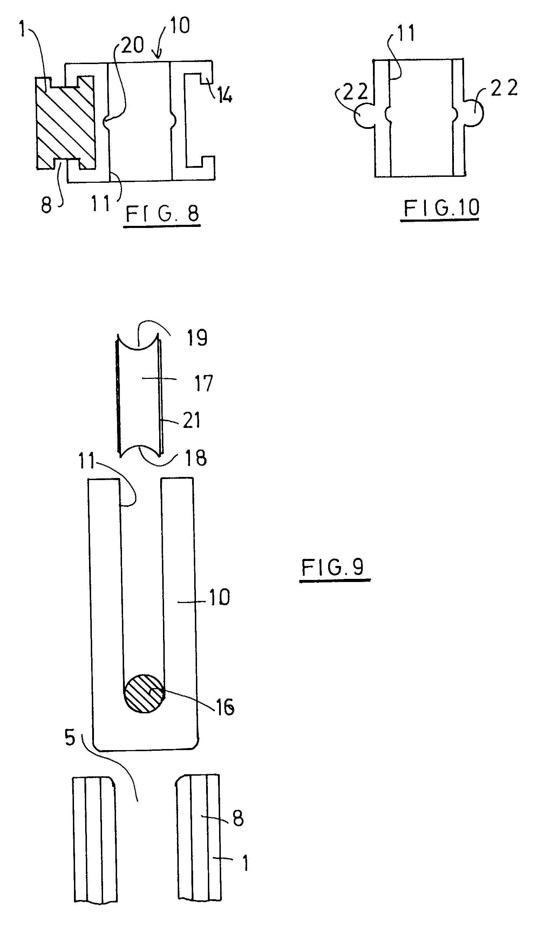

Die gegenseitige Zuordnung zwischen dem Träger 1 und dem Lagereinsatz 10 geht aus Figur 8 hervor. Die Figur 8 zeigt schematisch den Zustand, dass ein Einsatz 10 in einen nur teilweise dargestellten Träger eingeschoben ist. Die einander zugewandten Stege 14 greifen dabei in die eine Hälfte der Nut 8 ein.

Auf der gegenüberliegenden Seite könnte ein zweiter Lagereinsatz 10 eingeschoben werden. Durch das Hintergreifen der Stege 14 in die Nuten 8 wird erreicht, dass sich die Innenwände 11 der Einsätze 10 nicht nach innen verformen können, so dass die Innenwände 11 überall den gleichen Abstand aufweisen und damit parallel bleiben.

Figur 9 zeigt stark vereinfacht die gegenseitige Zuordnung zwischen einer Aufnahme 5 eines Trägers 1, einem Einsatz 10 und der zu lagernden Welle 16. Die Welle 16 weist einen Durchmesser auf, der dem Abstand der beiden Innenwände 11 des Einsatzes 10 entspricht. Die Welle 16 ist über die Hälfte ihres Umfangs durch den bogenförmigen Abschnitt 12 des Einsatzes 10 geführt. Von oben her kann in den Einsatz 10 ein Distanzeinsatz 17 eingeschoben werden, der den Abstand zwischen den Innenwänden 11 des Einsatzes 10 ausfüllt. Das untere Ende des Distanzeinsatzes und sein oberes Ende 19 weisen eine kreisbogenförmige konkave Ausbildung auf. Wird der Einsatz 17 von oben her in den Einsatz 10 eingeschoben, wird die Welle 16 praktisch über ihren gesamten Umfang gelagert. Gleichzeitig dient der Einsatz 17 dazu, das Durchtreten von Flüssigkeit durch den Schlitz zu verhindern. Das obere Ende 19 dient zur Lagerung einer über der Welle 16 angeordneten weiteren Welle einer Transportwalze.

Aus den Figuren 6, 7 und 8 ergibt sich, dass die Innenwände 11 des Einsatzes 10 eine in Längsrichtung verlaufende Rinne aufweisen. An der den Innenwänden 11 zugewandten Außenseite enthält der Einsatz 17 eine vorspringende Rippe 21, die an die Rinne 20 angepasst ist. Die Rinne 20 und die Rippe 21 bilden also eine Führung, die nicht nur das Ausrichten des Distanzeinsatzes 17 gegenüber dem Einsatz 10 bewirkt, sondern auch ein Herausschieben in Richtung der Achse der Welle 16 verhindert.

Während bei den bislang abgehandelten Ausführungsformen das Verformen der Seitenwände 11 des Einsatzes 10 nach innen durch das Zusammenwirken der Stege 14 und der Nuten 8 verhindert wurde, zeigt die Ausführungsform nach Figur 10 an der Außenseite der Schenkel des Einsatzes 10 eine Rippe 22, die im Bereich des Übergangs zu dem Einsatz einen Hinterschnitt bildet. Dieser Einsatz kann mit einer entsprechend gestalteten Innenwand der Aufnahme 5 eines Trägers zusammenwirken, um ebenfalls eine Verformung der Seitenwände 11 des Einsatzes nach innen zu verhindern.

## Patentansprüche

1. Anordnung zur Lagerung von Transportwalzen in einer Vorrichtung zur Bearbeitung von Leiterplatten, mit
1.1 einem Paar von Trägern (1), die
1.1.1 für jede Transportwalze eine Aufnahme (5) aufweisen,
1.2 einem Paar von Einsätzen (10), die
1.2.1 in die Aufnahmen (5) der Träger (1) einsetzbar sind und
1.2.2 eine Lagerung für die Transportwalzen bilden, wobei
1.2.3 der Einsatz (10) für die Lagerung der Walzen derart angeordnet ist, dass seine die Lagerung bildenden inneren Begrenzungswände (11) parallel zueinander bleiben.

2. Anordnung nach Anspruch 1, bei der die Aufnahmen (5) der Träger (1) als oben offene Schlitze ausgebildet sind.

3. Anordnung nach Anspruch 1 oder 2, bei der die Einsätze (10) für die Lagerungen der Wellen einen seine Innenwände (11) verbindenden kreiszylindrischen Endabschnitt (12) aufweisen.

4. Anordnung nach einem der vorhergehenden Ansprüche, bei der die Träger (1) mit den Einsätzen (10) zusammenwirkende Führungen aufweisen.

5. Anordnung nach Anspruch 4, bei der die Führungen einen Hinterschnitt bilden.

6. Anordnung nach Anspruch 5, bei der der Hinterschnitt durch Nuten (8) und/oder Rippen (14) in den senkrecht zur Drehachse der Transportwalzen verlaufenden Seitenwänden (7) der Träger (1) gebildet wird.

7. Anordnung nach Anspruch 5, bei der der Hinterschnitt durch hinterschnittene Nuten und/oder Rippen (22) in den einander zugewandten Seitenwänden (6) der Aufnahmen (5) der Träger (1) gebildet wird.

8. Anordnung nach einem der vorhergehenden Ansprüche, mit einem in den Einsatz (10) einsetzbaren Distanzeinsatz (17), der den Abstand zwischen den einander zugewandten Innenwänden (11) des Einsatzes (10) ausfüllt.

9. Anordnung nach Anspruch 8, bei der der Distanzeinsatz (17) von der Oberseite her in den Einsatz (10) einschiebbar ist.

10. Anordnung nach Anspruch 8 oder 9, mit einer Führung zwischen den Distanzeinsatz (17) und dem Einsatz (10), die den Distanzeinsatz (17) gegebenenfalls gegen ein Herausschieben in Richtung der Achse der Transportwalzen sichert.

11. Anordnung nach einem der Ansprüche 8 bis 10, bei der das untere und/oder das obere Ende (18, 19) des Distanzeinsatzes (17) eine konkav gebogene Ausbildung aufweist.
